(19) **Europäisches Patentamt**
**European Patent Office**
**Office européen des brevets**

(11) **EP 2 943 051 B1**

(12) **EUROPEAN PATENT SPECIFICATION**

(45) Date of publication and mention
of the grant of the patent:
**11.09.2019 Bulletin 2019/37**

(51) Int Cl.:
**H05K 13/04** *(2006.01)*    **H05K 13/08** *(2006.01)*

(21) Application number: **13869913.7**

(86) International application number:
**PCT/JP2013/050015**

(22) Date of filing: **07.01.2013**

(87) International publication number:
**WO 2014/106892 (10.07.2014 Gazette 2014/28)**

(54) **COMPONENT MOUNTING MACHINE AND COMPONENT MOUNTING METHOD**

MASCHINE ZUR MONTAGE VON KOMPONENTEN UND VERFAHREN ZUR MONTAGE VON KOMPONENTEN

MACHINE DE MONTAGE DE COMPOSANTS ET PROCÉDÉ DE MONTAGE DE COMPOSANTS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**11.11.2015 Bulletin 2015/46**

(73) Proprietor: **FUJI Corporation**
**Chiryu**
**Aichi (JP)**

(72) Inventors:
• **ITO, Toshiya**
 **Chiryu, Aichi (JP)**

• **IISAKA, Jun**
 **Chiryu, Aichi (JP)**

(74) Representative: **Grünecker Patent- und Rechtsanwälte**
**PartG mbB**
**Leopoldstraße 4**
**80802 München (DE)**

(56) References cited:
 **EP-A2- 1 239 719     JP-A- 2006 128 253**
 **JP-A- 2007 173 855     JP-A- 2007 220 837**
 **JP-A- 2011 091 181     JP-A- 2011 171 343**

## Description

Technical Field

The present invention relates to a component mounting machine in which a component supplied from a component supply device is mounted on a pad pattern of a circuit board or a solder printing pattern formed by performing screen printing on the pad pattern, and a component mounting method.

Background Art

As disclosed in PTL 1 (Japanese Patent No. 3983274), for example, a method of mounting a component on a circuit board is broadly divided into a method of performing screen printing with solder on a pad pattern of the circuit board and mounting a component on the solder printing pattern thereof, and a method of transferring solder or flux to a terminal portion (a bump) of the component and mounting the component on the pad pattern of the circuit board. A further example of a component mounting machine is disclosed in PTL 2.

Citation List

Patent Literature

PTL 1: Japanese Patent No. 3983274
PTL 2: EP 1 239 719 A2

Summary of Invention

Technical Problem

When a component is mounted on a solder printing pattern formed by performing screen printing on a pad pattern of a circuit board, there is a need to consider the issue of printing misalignment of the solder printing pattern with respect to the pad pattern. Therefore, it is desirable to correct a mounting position of the component based on a position of the solder printing pattern as a fiducial point. Meanwhile, when the component is mounted on the pad pattern of the circuit board, there is no need to consider the issue of printing misalignment of the solder printing pattern. Therefore, the mounting position of the component may be corrected based on a position of the pad pattern as a fiducial point. Accordingly, a fiducial position mark for correcting the mounting position needs to be switched between the component to be mounted on the pad pattern and the component to be mounted on the solder printing pattern.

Generally, there are various types of components in the component to be mounted on one circuit board, and there is a case where the component to be mounted on the pad pattern is mixed with the component to be mounted on the solder printing pattern. Therefore, in all the components to be mounted on the circuit board, a worker determines whether the mount component is the component to be mounted on the pad pattern or the component to be mounted on the solder printing pattern, thereby designating the fiducial position mark for each component before starting production. Accordingly, it is annoying for the worker to designate the fiducial position mark for each component before starting production, and there is a possibility that an incorrect fiducial position mark is designated due to a manipulation mistake, thereby causing degradation of reliability of a connection in the component mounting board to be produced.

In order to solve the problem, the invention provides a component mounting machine in which it is automatically determined whether the mount component is the component to be mounted on the pad pattern or the component to be mounted on the solder printing pattern, the component can be accurately mounted on the pad pattern or the solder printing pattern, and reliability of a connection in the component mounting board to be produced can be improved, and a component mounting method.

Solution to Problem

In order to achieve the object described above, according to the invention, there is provided a component mounting machine and a component mounting method for mounting a component supplied from a component supply device on a pad pattern of a circuit board or a solder printing pattern formed by performing screen printing on the pad pattern. A board mark which becomes a fiducial position mark of the pad pattern and a solder mark which becomes a fiducial position mark of the solder printing pattern are formed on the circuit board. It is determined whether a mount component is the component to be mounted on the pad pattern or the component to be mounted on the solder printing pattern, and as a result, the component is mounted on the pad pattern by correcting a mounting position of the component with respect to the pad pattern based on a position of the board mark as a fiducial point which is imaged by a camera and is subjected to image processing when it is determined that the mount component is the component to be mounted on the pad pattern, while the component is mounted on the solder printing pattern by correcting the mounting position of the component with respect to the solder printing pattern based on a position of the solder mark as a fiducial point which is imaged by the camera and is subjected to image processing when it is determined that the mount component is the component to be mounted on the solder printing pattern. In this manner, the fiducial position mark can be automatically switched between the board mark and the solder mark by automatically determining whether the mount component is the component to be mounted on the pad pattern or the component to be mounted on the solder printing pattern, and the component can be accurately mounted on the pad pattern or the solder printing pattern. Thus, reliability of a connection in a component mounting board to be produced can be improved.

In this case, the board mark may be collectively formed with the pad pattern at a position different from that of the pad pattern, or the pad pattern the position of which can be specified through image recognition may be used as the board mark among the pad patterns formed in the circuit board.

Similarly, the solder mark may be collectively formed with the solder printing pattern at a position different from that of the solder printing pattern by performing screen printing, or the solder printing pattern the position of which can be specified through image recognition may be used as the solder mark among the solder printing patterns formed by performing screen printing on the circuit board.

According to the invention, when screen printing of the solder printing pattern is not performed on the pad pattern existing at a component mounting position, it may be determined that the mount component is the component to be mounted on the pad pattern, and when screen printing of the solder printing pattern is performed on the pad pattern existing at the component mounting position, it may be determined that the mount component is the component to be mounted on the solder printing pattern.

In this case, when application of solder is performed on the pad pattern existing at the component mounting position by a method other than screen printing (for example, pin transferring, a dispenser, dipping, an ink jet, and the like), it may be determined that the mount component is the component to be mounted on the pad pattern. When application of solder is performed on the pad pattern by a method other than screen printing, there is a possibility that an amount of positional misalignment of solder vary or an application amount of solder vary in each pad pattern. Therefore, it is better to correct the mounting position of the component based on the position of the board mark (the position of the pad pattern) as the fiducial point in order to allow the component to be stably connected to the pad pattern.

When the mount component is the component to be mounted after transferring solder or flux to a terminal portion thereof, it may be determined to be the component to be mounted on the pad pattern. The reason is that when solder or flux is transferred to the terminal portion of the component, even though there is no solder printing pattern on the pad pattern, the terminal portion of the component can be connected to the pad pattern.

When executing the invention, image processing component data used when performing image recognition of the component to be mounted may include data for designating whether the mount component is the component to be mounted on the pad pattern or the component to be mounted on the solder printing pattern, and it may be determined whether the mount component is the component to be mounted on the pad pattern or the component to be mounted on the solder printing pattern, with reference to the image processing component data.

Brief Description of Drawings

Fig. 1 is a longitudinal sectional diagram illustrating a configuration of a main portion of a component mounting machine showing an example of the invention.
Fig. 2 is a block diagram schematically illustrating a configuration of a control system of the component mounting machine.
Fig. 3(a) is a diagram illustrating a mounting surface of a circuit board before screen printing of a solder printing pattern is performed, Fig. 3(b) is a diagram illustrating the mounting surface of the circuit board after screen printing of the solder printing pattern is performed, and Fig. 3(c) is a diagram illustrating a state where a component is mounted on the circuit board.
Fig. 4 is a diagram illustrating the mounting surface of a multi-piece board.
Fig. 5 is a flow chart illustrating a processing flow of a component mounting control program.
Fig. 6 is a flow chart illustrating a processing flow of a component mounting skipping determination program.
Fig. 7 is a block diagram illustrating a function of a control device of the component mounting machine.

Description of Embodiment

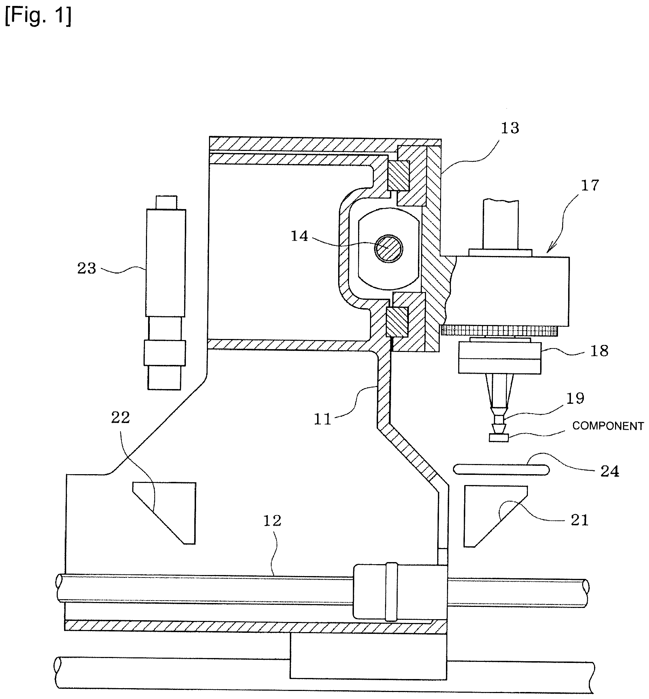

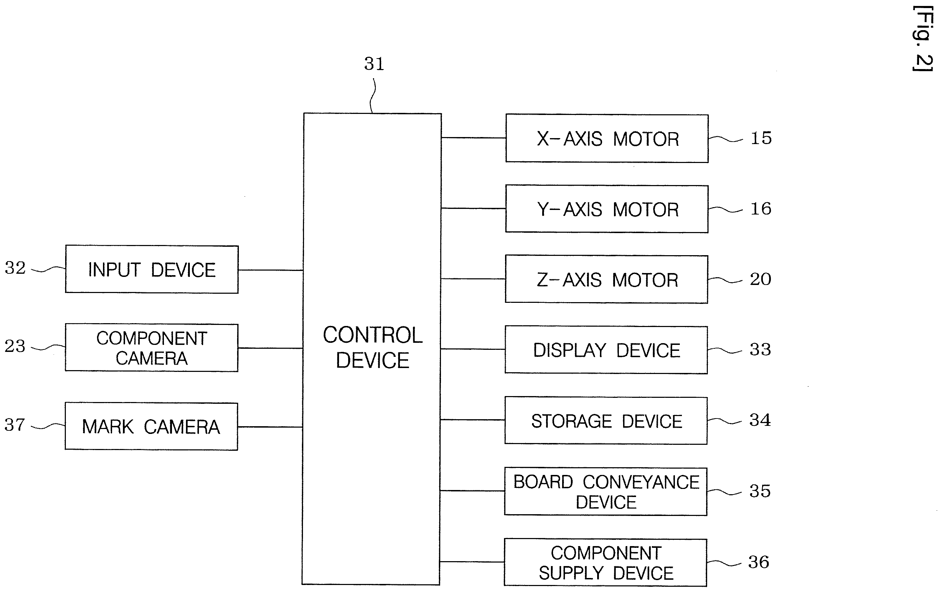

Hereinafter, descriptions will be given regarding an example in which a form for executing the invention is specified. First, an overall schematic configuration of a component mounting machine will be described with reference to Figs. 1 and 2.

An X-axis slide 11 is slidably installed in an X-axis direction (the lateral direction in Fig. 1) by using an X-axis ball screw 12. With respect to the X-axis slide 11, a Y-axis slide 13 is slidably installed in a Y-axis direction (the direction perpendicular to the sheet plane in Fig. 1) by using a Y-axis ball screw 14. The X-axis ball screw 12 and the Y-axis ball screw 14 are respectively driven by an X-axis motor 15 (refer to Fig. 2) and a Y-axis motor 16 (refer to Fig. 2).

A mounting head 17 is installed in the Y-axis slide 13. A vacuum holder 18 is installed in the mounting head 17 through a Z-axis drive mechanism (not illustrated) so as to be lifted and lowered in a Z-axis direction (a vertical direction). A suction nozzle 19 is downwardly attached to the vacuum holder 18. The Z-axis drive mechanism is driven by a Z-axis motor 20 (refer to Fig. 2).

Meanwhile, a component camera 23 (a component imaging camera) which images a component adsorbed to the suction nozzle 19, from the lower face side through a pair of reflecting mirrors 21 and 22 is downwardly installed in the X-axis slide 11. A ring-shaped lighting device 24 for illuminating a component adsorbed to the suction nozzle 19 from the lower face side thereof is provided above the reflecting mirror 21 which is positioned below the component adsorbed to the suction nozzle 19.

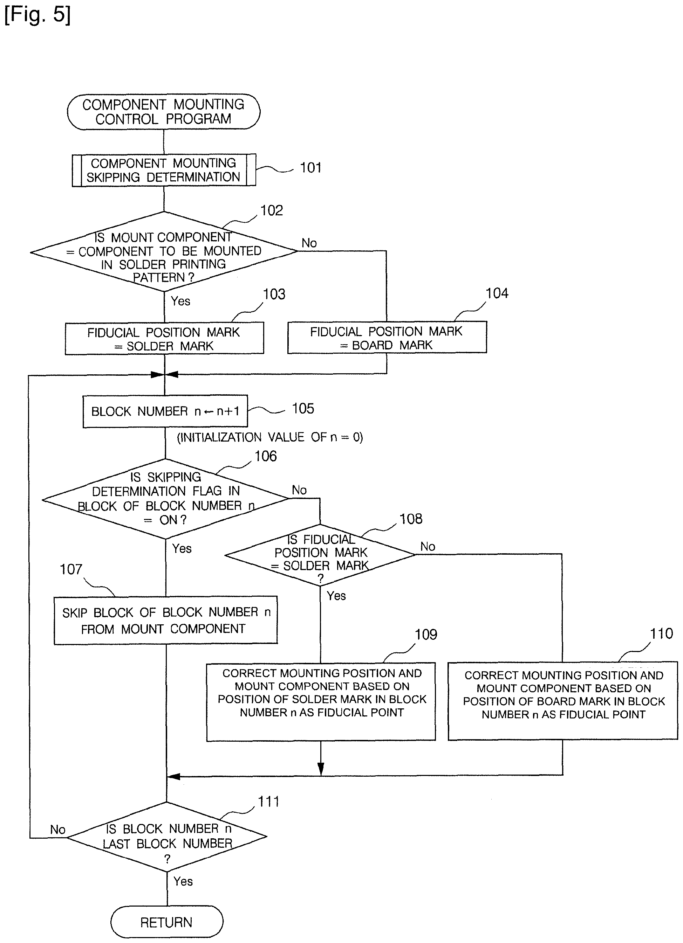

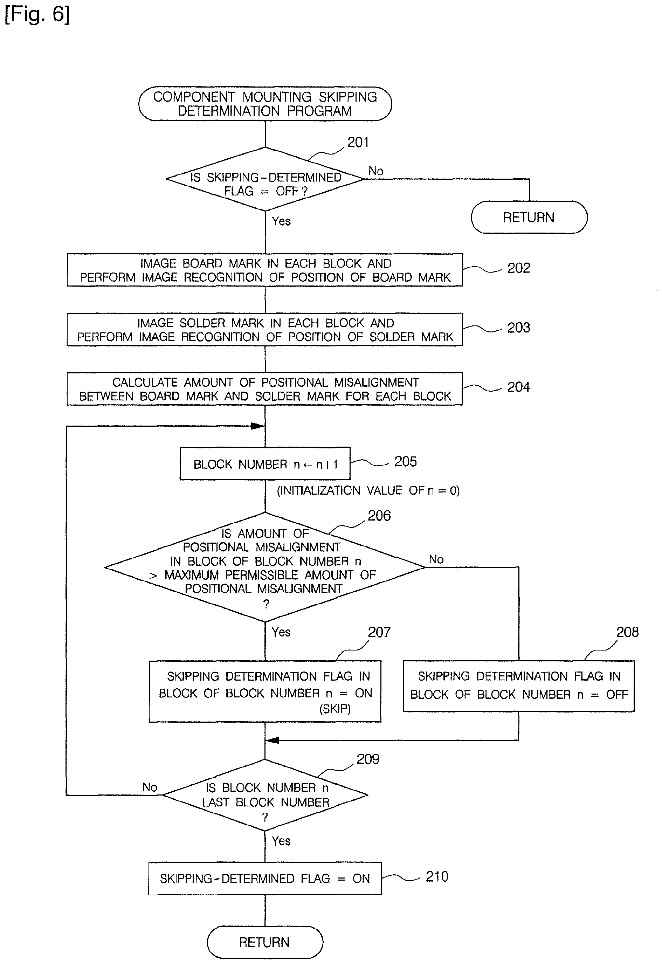

As illustrated in Fig. 2, input devices 32 such as a keyboard, a mouse, and a touch panel; display devices 33 such as a liquid crystal display, and CRT; and a storage device 34 which stores each program in Figs. 5 and 6 described below, and image processing component data are connected to the control device 31 of the component mounting machine. In addition, the component mounting machine is provided with a board conveyance device 35 which conveys a circuit board, a component supply device 36 such as a tape feeder which supplies a component to be mounted on the circuit board, a mark camera 37 (a mark imaging camera) which images an imaging target portion of the circuit board, and the like.

The control device 31 of the component mounting machine controls an operation in which a component supplied from the component supply device 36 is adsorbed to the suction nozzle 19 so as to be mounted on the circuit board while the component mounting machine is in operation. The control device 31 causes the component adsorbed to the suction nozzle 19 to be imaged by the component camera 23 while the component is moved above the circuit board. The control device 31 performs processing of an imaged image so as to determine an adsorption posture of the component, the presence or absence of the component, and the like.

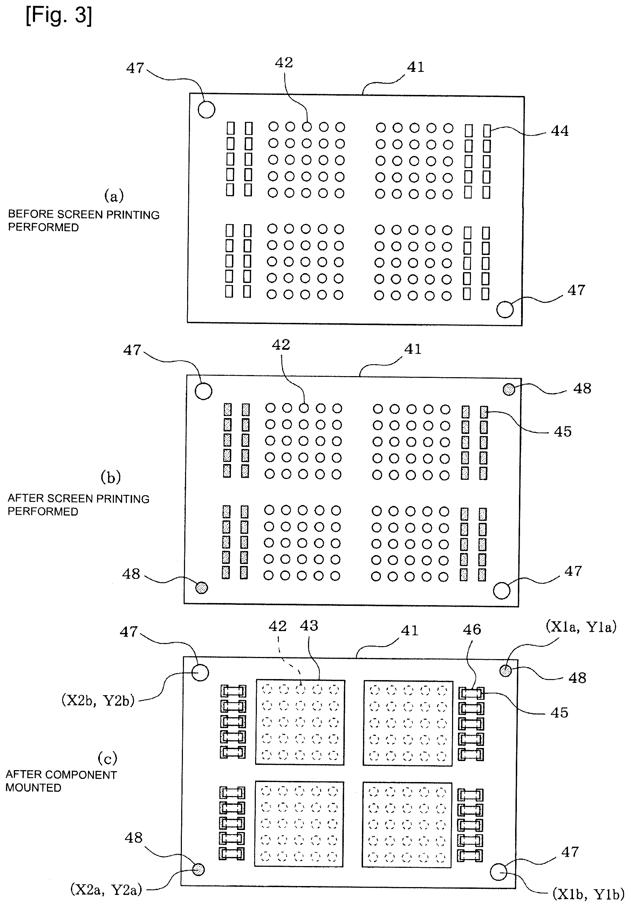

Incidentally, as illustrated in Fig. 3, there are various types of components in the component to be mounted on one circuit board 41, and there is a case where a component 43 to be mounted on a pad pattern 42 formed on the circuit board 41 is mixed with a component 46 to be mounted on a solder printing pattern 45 formed by performing screen printing on a pad pattern 44 of the circuit board 41.

When the component 46 is mounted on the solder printing pattern 45 formed by performing screen printing on the pad pattern 44, there is a need to consider the issue of printing misalignment of the solder printing pattern 45 with respect to the pad pattern 44. Therefore, it is desirable that a mounting position of the component 46 is corrected based on a position of the solder printing pattern 45 as a fiducial point. Meanwhile, when the component 43 is mounted on the pad pattern 42 of the circuit board 41, there is no need to consider the issue of printing misalignment of the solder printing pattern 45. Therefore, a mounting position of the component 43 may be corrected based on a position of the pad pattern 42 as a fiducial point.

In consideration of such circumstances, in the present example, two board marks 47 which become marks for the fiducial positions of the pad patterns 42 and 44 are formed collectively with the pad patterns 42 and 44 at two corner portions in a diagonal direction of the circuit board 41. In addition, when performing screen printing of the solder printing pattern 45, two solder marks 48 which become marks for fiducial positions of the solder printing pattern 45 are subjected to screen printing to be formed collectively with the solder printing pattern 45 at two corner portions in the other diagonal direction of the circuit board 41.

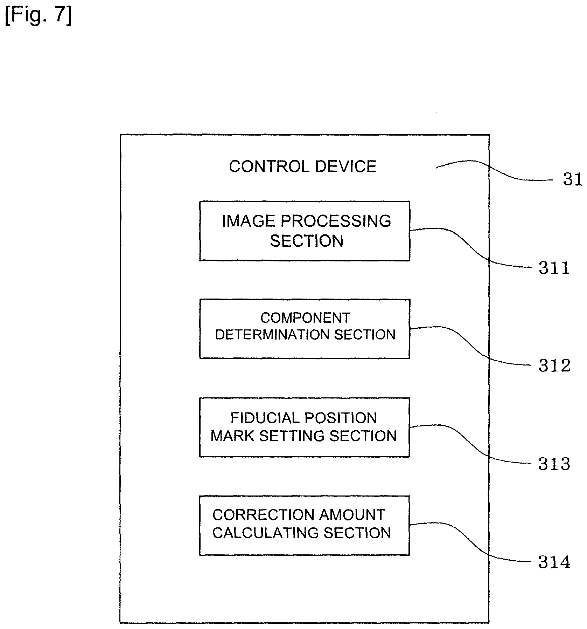

Then, as illustrated in Fig. 7, the control device 31 of the component mounting machine includes an image processing section 311 which performs image processing, having the board mark 47 and/or the solder mark 48 as a fiducial position mark for mounting a component imaged by the mark camera 37, and performs calculation processing of the position of the fiducial position mark; a component determination section 312 which performs processing of determining whether the mount component is the component 43 to be mounted on the pad pattern 42 or the component 46 to be mounted on the solder printing pattern 45; a fiducial position mark setting section 313 which sets the fiducial position mark for mounting the component between the board mark 47 and the solder mark 48 based on a determination result acquired by the component determination section 312; and a correction amount calculating section 314 which computes a correction amount of the mounting position of the component to be mounted based on an image of the fiducial position mark set by the fiducial position mark setting section 313 and is imaged by the mark camera 37.

In the present example, the control device 31 of the component mounting machine executes each program in Figs. 5 and 6 described below so as to realize functions of the image processing section 311, the component determination section 312, the fiducial position mark setting section 313, and the correction amount calculating section 314, thereby determining whether the mount component is the component 43 to be mounted on the pad pattern 42 or the component to be mounted on the solder printing pattern 45. As a result, when it is determined that the mount component is the component to be mounted on the pad pattern 42, the board mark 47 is imaged by the mark camera 37 and the position of the board mark 47 is subjected to image recognition. The mounting position of the component 43 is corrected with respect to the pad pattern 42 based on the position of the board mark 47 as the fiducial point, thereby mounting the component 43 on the pad pattern 42. Meanwhile, when it is determined that the mount component is the component 46 to be mounted on the solder printing pattern 45, the solder mark 48 is imaged by the mark camera 37 and the position of the solder mark 48 is subjected to image recognition. The mounting position of the component 46 is corrected with respect to the solder printing pattern 45 based on the position of the solder mark 48 as the fiducial point, thereby mounting the component 46 on the solder printing pattern 45.

The board mark 47 is not limited to that formed at a position different from the pad patterns 42 and 44. A pad pattern 42 the position of which can be specified through image recognition may be used as the board mark among the pad patterns 42 formed in the circuit board 41.

Similarly, the solder mark 48 is not limited to that formed at a position different from the solder printing pattern 45. A solder printing pattern 45 the position of which can be specified through image recognition may be used as the solder mark among the solder printing patterns 45 formed by performing screen printing on the circuit board 41.

In the present example, both the board mark 47 and the solder mark 48 are caused to be different from each other in size in order to be distinguishable. However, both may be caused to be different from each other in shape. Even when both are identical to each other in size and shape, both may be distinguishable depending on the position to be formed.

In the image processing component data used when the component adsorbed to the suction nozzle 19 is imaged by the component camera 23 and is subjected to image recognition, data for designating whether the mount component is the component 43 to be mounted on the pad pattern 42 or the component 46 to be mounted on the solder printing pattern 45 is included. Accordingly, when the component adsorbed to the suction nozzle 19 is subjected to image recognition, with reference to the image processing component data stored in the storage device 34, the control device 31 of the component mounting machine causes the component adsorbed to the suction nozzle 19 to be subjected to image recognition, thereby being able to automatically determine whether the component is the component 43 to be mounted on the pad pattern 42 or the component 46 to be mounted on the solder printing pattern 45.

In the present example, when screen printing of the solder printing pattern is not performed on the pad pattern existing at a component mounting position, it is determined that the mount component is the component to be mounted on the pad pattern, and when screen printing of the solder printing pattern is performed on the pad pattern existing at the component mounting position, it is determined that the mount component is the component to be mounted on the solder printing pattern.

When application of solder is performed on the pad pattern existing at the component mounting position by a method other than screen printing (for example, pin transferring, a dispenser, dipping, an ink jet, and the like), it is determined that the mount component is the component to be mounted on the pad pattern. When application of solder is performed on the pad pattern by a method other than screen printing, there is a possibility that an amount of positional misalignment of solder vary or an application amount of solder vary in each pad pattern. Therefore, it is better to correct the mounting position of the component based on the position of the board mark 47 as the fiducial point in order to allow the component to be stably connected to the pad pattern.

In the present example, when the mount component is the component to be mounted after transferring solder or flux to a terminal portion (a bump), even though screen printing of the solder printing pattern is performed on the pad pattern of the component mounting position, it is determined to be the component to be mounted on the pad pattern. The reason is that even though an amount of printing misalignment of the solder printing pattern is significant with respect to the pad pattern, when solder or flux is transferred to the terminal portion of the component, the terminal portion of the component can be connected to the pad pattern.

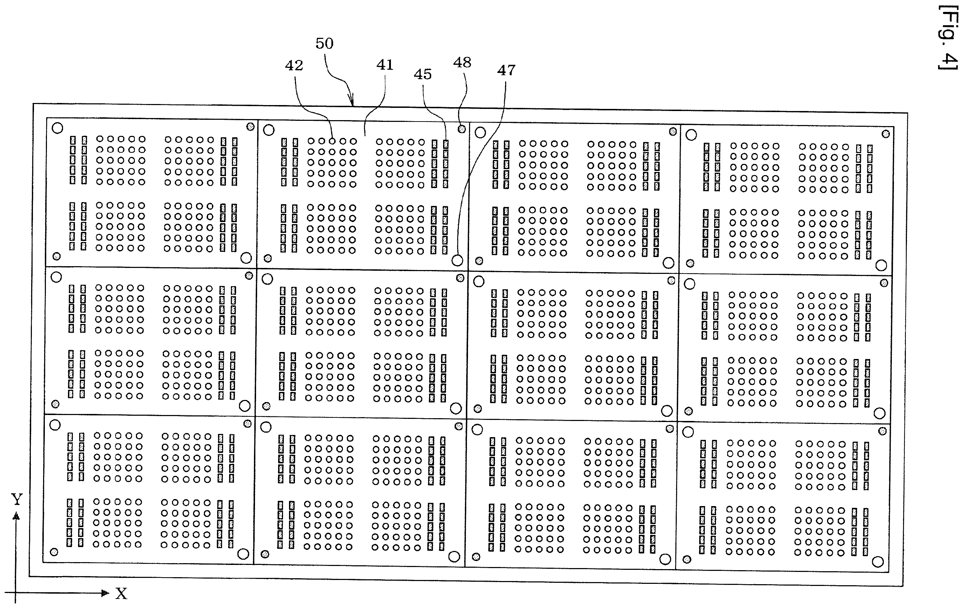

Incidentally, when producing small-sized component mounting boards, in order to improve productivity, as illustrated in Fig. 4, there is a mounting method in which the component is mounted in each block of the circuit board 41 in a multi-piece board 50 having integrally arranged multiple blocks of the circuit boards 41, and after all the components are completed to be mounted in all the blocks of the circuit boards 41, the multi-piece board 50 is divided along border lines (break grooves and the like) formed between the blocks of the circuit boards 41 and is split into individual component mounting boards.

When the invention is applied to such a multi-piece board 50, the board mark 47 and the solder mark 48 are formed on each block of the multi-piece board 50, and the component is mounted on the pad pattern 42 or the solder printing pattern 45 while switching the fiducial position mark between the board mark 47 and the solder mark 48 in accordance with the component to be mounted.

In the multi-piece board 50, due to unevenness in positional accuracy of each block of the circuit board 41 or printing accuracy of screen printing, each block of the circuit board 41 differs in the amount of printing misalignment of the solder printing pattern 45 with respect to the pad pattern 44 of each block of the circuit board 41, and there is a case where the amount of printing misalignment stands out in a portion of the blocks. Particularly, in a multi-piece board 50 made of ceramic, since unevenness of positional accuracy of each block of the circuit board 41 tends to be magnified due to firing shrinkage, the amount of printing misalignment of the solder printing pattern 45 with respect to the pad pattern 44 is likely to stand out in a portion of the blocks. When the amount of printing misalignment excessively stands out, connection failure easily occurs between the pad pattern 44 and the solder printing pattern 45. Therefore, when the component 46 is mounted on the solder printing pattern 45, mounting failure occurs, thereby resulting in producing defective products.

As a countermeasure thereof, in the present example, the board mark 47 and the solder mark 48 are imaged by the mark camera 37 in each block of the circuit board 41 in the multi-piece board 50, and the positions of the board mark 47 and the solder mark 48 are subjected to image recognition. Then, the amount of positional misalignment between the board mark 47 and the solder mark 48 is calculated, and the amount of positional misalignment thereof is compared to a determination threshold value which corresponds to the maximum permissible amount of positional misalignment. When the amount of positional misalignment exceeds the determination threshold value, it is determined that the amount of printing misalignment of the solder printing pattern 45 with respect to the pad pattern 44 of the block exceeds the maximum permissible amount of positional misalignment (that is, connection failure between the pad pattern 44 and the solder printing pattern 45 easily occurs), thereby skipping mounting of the component in the block. Thus, the component is not mounted in the block.

The above-described component mounting control of the present example is executed by the control device 31 of the component mounting machine in accordance with each program in Figs. 5 and 6. Hereinafter, processing contents of each program in Figs. 5 and 6 will be described.

[Component Mounting Control Program]

The component mounting control program in Fig. 5 is executed for each component to be mounted on the multi-piece board 50 and functions as control means for controlling a component mounting operation by determining whether the mount component is the component 46 to be mounted on the solder printing pattern 45 or the component 43 to be mounted on the pad pattern 42.

When the program starts, first of all, in Step 101, the below-described component mounting skipping determination program of Fig. 6 is executed so as to perform determination for each block of the circuit board 41 in the multi-piece board 50 whether or not mounting of the component is subjected to skipping. In accordance with the determination result, the skipping determination flag of each block is switched between an ON state (skip) and an OFF state (execute mounting of component).

Thereafter, the procedure proceeds to Step 102, and the component determination section 312 of the control device 31 determines whether or not the mount component is the component 46 to be mounted on the solder printing pattern 45. In the present example, the image processing component data used in image processing of the mount component includes data for designating whether the mount component is the component 43 to be mounted on the pad pattern 42 or the component 46 to be mounted on the solder printing pattern 45. Accordingly, when the mount component is imaged by the component camera 23 and is subjected to image processing, with reference to the image processing component data, it is determined whether or not the mount component is the component 46 to be mounted on the solder printing pattern 45. As a result, when it is determined that the mount component is the component 46 to be mounted on the solder printing pattern 45, the procedure proceeds to Step 103, and the fiducial position mark setting section 313 sets the solder mark 48 as the fiducial position mark for mounting a component.

Meanwhile, in the aforementioned Step 102, when the component determination section 312 determines that the mount component is not the component 46 to be mounted on the solder printing pattern 45 (that is, the mount component is the component 43 to be mounted on the pad pattern 42), the procedure proceeds to Step 104, and the fiducial position mark setting section 313 sets the board mark 47 as the fiducial position mark for mounting a component.

After setting the fiducial position mark by the fiducial position mark setting section 313, the procedure proceeds to Step 105, and a block number n of the multi-piece board 50 is subjected to increments. Since the block number n is reset to "zero" through processing of initialization when power is applied to the control device 31, the first block number n is set to "1" through processing in the aforementioned Step 105.

Thereafter, the procedure proceeds to Step 106, thereby performing skip determination processing for determining whether or not the skipping determination flag in the block of the block number n set by the below-described component mounting skipping determination program of Fig. 6 is in the ON state (skip). When it is determined that the skipping determination flag in the block of the block number n is in the ON state, the procedure proceeds to Step 107, thereby skipping mounting of the component with respect to the block of the block number n. Thereafter, the procedure proceeds to Step 111, and it is determined whether or not the block number n is the last block number. When it is determined that the block number n is not the last block number, the procedure returns to the above-described Step 105, and the block number n is subjected to increments, thereby performing skip determination processing in the aforementioned Step 106 again.

In the aforementioned Step 106, when it is determined that the skipping determination flag in the block of the block number n is in the OFF state (do not skip), the procedure proceeds to Step 108, and it is determined whether or not the fiducial position mark is set to the solder mark 48. When it is determined that the fiducial position mark is set to the solder mark 48, the procedure proceeds to Step 109, and the correction amount calculating section 314 computes a correction amount of the mounting position based on the position of the solder mark 48 in the block of the block number n as the fiducial point, thereby mounting the component 46 on the solder printing pattern 45 in the block of the block number n.

Meanwhile, in the aforementioned Step 108, when it is determined that the fiducial position mark is not set to the solder mark 48 (that is, the fiducial position mark is set to the board mark 47), the procedure proceeds to Step 110, and the correction amount calculating section 314 computes a correction amount of the mounting position based on the position of the board mark 47 in the block of the block number n as the fiducial point, thereby mounting the component 43 on the pad pattern 42 in the block of the block number n.

Thereafter, the procedure proceeds to Step 111, and it is determined whether or not the block number n is the last block number (whether or not execution of mounting or skipping of the component is completed in all the blocks of the multi-piece board 50) . As a result, when it is determined that the block number n is not the last block number, the procedure returns to the aforementioned Step 105, and the block number n is subjected to increments, thereby repeatedly executing processing after the above-described Step 106. Thereafter, in the aforementioned Step 111, when it is determined that the block number n is the last block number, it is determined that execution of mounting or skipping of the component is completed in all the blocks of the multi-piece board 50, thereby ending the program.

[Component Mounting Skipping Determination Program]

The component mounting skipping determination program of Fig. 6 is a subroutine which is executed in Step 101 of the component mounting control program of Fig. 5 described above. When the component mounting skipping determination program of Fig. 6 starts, first of all, in Step 201, it is determined whether or not a skipping-determined flag which is set in Step 210 described below is in the OFF state (skipping not determined) . When it is determined that the skipping-determined flag is in the ON state (skipping determined), the program ends without performing the next processing step.

Meanwhile, in the aforementioned Step 201, when it is determined that the skipping-determined flag is in the OFF state (not determined to skip), the procedure proceeds to Step 202, the mark camera 37 images two board marks 47 of each block of the multi-piece board 50 one by one, and the image processing section 311 of the control device 31 performs image recognition for positions (X1a and Y1a) and (X2a and Y2a) of each board mark 47. Then, in the following Step 203, the mark camera 37 images two solder marks 48 of each block of the multi-piece board 50 one by one, and the image processing section 311 of the control device 31 performs image recognition for positions (X1b and Y1b) and (X2b and Y2b) of each solder mark 48.

Thereafter, the procedure proceeds to Step 204, and the image processing section 311 calculates amounts $\Delta X$ and $\Delta Y$ of positional misalignment in an X-direction and a Y-direction between the board mark 47 and the solder mark 48 for each block of the multi-piece board 50 through any one of the following methods.

<<Method of Calculating Amounts $\Delta X$ and $\Delta Y$ of Positional Misalignment (No. 1)>>

Since two of each of the board mark 47 and the solder mark 48 are formed in the diagonal direction for each block, for example, the amounts $\Delta X$ and $\Delta Y$ of positional misalignment in the X-direction and the Y-direction between median points of the two board marks 47 [(X1a + X2a) / 2 and (X1b + X2b) / 2] and median points of the two solder marks 48 [(Y1a + Y2a) / 2 and (Y1b + Y2b) / 2] are calculated as the amounts $\Delta X$ and $\Delta Y$ of positional misalignment between the board marks 47 and the solder marks 48 in the X-direction and the Y-direction by using the following expressions.

$$\Delta X = |(X1a + X2a) / 2 - (X1b + X2b) / 2|$$

$$\Delta Y = |(Y1a + Y2a) / 2 - (Y1b + Y2b) / 2|$$

<<Method of Calculating Amounts ΔX and ΔY of Positional Misalignment (No. 2)>>

In a case where the positional relationships between the positions of the two board marks 47 (X1a and Y1a) and (X2a and Y2a), and the positions of the two solder marks 48 (X1b and Y1b) and (X2b and Y2b) are formed to be X1a = X1b, X2a = X2b, Y1a = Y2b, and Y2a = Y1b when there is no positional misalignment, amounts of positional misalignment ΔX1 and ΔX2 in the X-direction, and amount of positional misalignment ΔY1 and ΔY2 in the Y-direction between the board marks 47 and the solder marks 48 are calculated by using the following expressions.

$$\Delta X1 = |X1a - X1b|$$

$$\Delta X2 = |X2a - X2b|$$

$$\Delta Y1 = |Y1a - Y2b|$$

$$\Delta Y2 = |Y2a - Y1b|$$

The greater amount between the two amounts of positional misalignment ΔX1 and ΔX2 in the X-direction calculated by using the above expressions is selected as the amount of positional misalignment ΔX of the block in the X-direction, and the greater amount between the two amounts of positional misalignment ΔY1 and ΔY2 in the Y-direction is selected as the amount of positional misalignment ΔY of the block in the Y-direction.
ΔX = MAX (ΔX1 and ΔX2)
ΔY = MAX (ΔY1 and ΔY2)

<<Method of Calculating Amounts ΔX and ΔY of Positional Misalignment (No. 3)>>

Only ΔX1 and ΔY1 are calculated (or only ΔX2 and ΔY2 are calculated) to be directly used as the amounts ΔX and ΔY of positional misalignment in the X-direction and the Y-direction.
ΔX = ΔX1 (or ΔX = ΔX2)
ΔY = ΔY1 (or ΔY = ΔY2)

Thereafter, the procedure proceeds to Step 205, and the block number n of the multi-piece board 50 is subjected to increments . Since the block number n is reset to "zero" through processing of initialization when power is applied to the control device 31, the first block number n is set to "1" through processing in the aforementioned Step 205.
Thereafter, the procedure proceeds to Step 206, and it is determined whether or not the amounts ΔX and ΔY of positional misalignment in the X-direction and the Y-direction in the block of the block number n exceed the determination threshold value corresponding to the maximum permissible amount of positional misalignment.
(1) ΔX > determination threshold value
(2) ΔY > determination threshold value

In this case, when any one of the amounts ΔX and ΔY of positional misalignment in the X-direction and the Y-direction exceeds the determination threshold value, it is determined that the amount of positional misalignment of the block exceeds the maximum permissible amount of positional misalignment, and when none of the amounts ΔX and ΔY of positional misalignment in the X-direction and the Y-direction exceeds the determination threshold value, it is determined that the amount of positional misalignment of the block does not exceed the maximum permissible amount of positional misalignment.

In Step 206 thereof, when it is determined that the amount of positional misalignment in the block of the block number n exceeds the maximum permissible amount of positional misalignment, the procedure proceeds to Step 207, and the skipping determination flag in the block of the block number n is set to be in the ON state (skip).

In contrast, in the aforementioned Step 206, when it is determined that the amount of positional misalignment in the block of the block number n does not exceed the maximum permissible amount of positional misalignment, the procedure proceeds to Step 208, and the skipping determination flag in the block of the block number n is caused to remain in the OFF state (do not skip). The skipping determination flag is reset to the OFF state through processing of initialization when power is applied to the control device 31.

Thereafter, the procedure proceeds to Step 209, and it is determined whether or not the block number n is the last block number (whether or not execution of mounting or skipping of the component is completed in all the blocks of the multi-piece board 50). As a result, when it is determined that the block number n is not the last block number, the procedure returns to the aforementioned Step 205, and the block number n is subjected to increments, thereby repeatedly executing skip determination processing after the above-described Step 206.

Thereafter, in the aforementioned Step 209, when it is determined that the block number n is the last block number, it is determined that skip determination processing after the Step 206 is completed in all the blocks of the multi-piece board 50. Then, the procedure proceeds to Step 210, and the skipping-determined flag is set to be in the ON state (skipping determined), thereby ending the program.

According to the present example described above, the component determination section 312 of the control device 31 determines whether the mount component is the component 43 to be mounted on the pad pattern 42 or the component 46 to be mounted on the solder printing pattern 45. As a result, when it is determined that the mount component is the component 43 to be mounted on the pad pattern 42, the fiducial position mark setting section 313 sets the board mark 47 as the fiducial position mark for mounting a component. The mark camera 37 images the board mark 47. The image processing section 311 performs image recognition of the position of the board mark 47. The correction amount computation section 314 corrects the mounting position of the component 43 with respect to the pad pattern 42 based on the position of the board mark 47 as the fiducial point. Then, the component 43 is mounted on the pad pattern 42. Meanwhile, when the component determination section 312 determines that the mount component is the component 46 to be mounted on the solder printing pattern 45, the fiducial position mark setting section 313 sets the solder mark 48 as the fiducial position mark for mounting a component. The mark camera 37 images the solder mark 48. The image processing section 311 performs image recognition of the position of the solder mark 48. The correction amount calculating section 314 corrects the mounting position of the component 46 with respect to the solder printing pattern 45 based on the position of the solder mark 48 as the fiducial point. Then, the component 46 is mounted on the solder printing pattern 45. Therefore, it is possible to automatically determine whether the mount component is the component 43 to be mounted on the pad pattern 42 or the component 46 to be mounted on the solder printing pattern 45, and it is possible to automatically switch the fiducial position mark between the board mark 47 and the solder mark 48. As a result, there is no need for a worker to designate the fiducial position mark for each component before starting production. Therefore, productivity can be improved, and there is no possibility that an incorrect fiducial position mark is designated due to a manipulation mistake. Moreover, the components 43 and 46 can be accurately mounted on the pad pattern 42 or the solder printing pattern 45, and reliability of a connection in the component mounting board to be produced can be improved.

In the above-described example, the data for designating whether the mount component is the component 43 to be mounted on the pad pattern 42 or the component 46 to be mounted on the solder printing pattern 45 is included in the image processing component data used when performing image processing of the component to be mounted. However, the invention is not limited thereto. For example, the data may be included in mounting position data and the like indicating the mounting order and mounting coordinates of each component to be mounted on the circuit board.

In the above-described example, after the component determination section 312 determines the component to be mounted, and the fiducial position mark setting section 313 sets the fiducial position mark for mounting a component, the mark camera 37 images the set fiducial position mark 47 or 48, and the image processing section 311 performs image processing of the position of the fiducial position mark 47 or 48. However, the invention is not limited to the processing order thereof.

For example, at the time when the circuit board is carried and positioned in the component mounting machine, the mark camera 37 may image the board mark 47 and the solder mark 48 as the fiducial position marks for mount components, and the image processing section 311 may calculate the positions of the board mark 47 and the solder mark 48. Thereafter, when mounting each component, the component determination section 312 may determine the component to be mounted, the fiducial position mark setting section 313 may set the fiducial position mark for mounting a component, and the correction amount calculating section 314 may compute the correction amount of the mounting position of the component based on the calculated position of each fiducial position mark. Since the fiducial position mark for mounting a component needs to be imaged only when carrying and positioning the circuit board. Therefore, the production time is shortened.

In addition, when the components to be mounted are shared by a plurality of the component mounting machines in order to mount multiple components on one circuit board, depending on the component mounting machine, there is a case where the component mounting machine handles only the component 43 to be mounted on the pad pattern 42 or only the component 46 to be mounted on the solder printing pattern 45. In such a case, information indicating whether the component to be mounted in each component mounting machine is configured to include only one type between the component 43 and the component 46 or to include both types of the component may be included in production related data which is the data related to production for each type of the circuit board, that is, data input to each component mounting machine before starting production for each type of the circuit board. Specifically, at the time when preparing each component mounting machine before production for each type of the circuit board, the component determination section 312 of each component mounting machine determines whether all the components to be mounted in the component mounting machine are configured to include only the components 43, are configured to include only the components 46, or include both types of the component, based on the production related data. In the component mounting machine which is determined to be mounted with only one type of the component between the component 43 and the component 46, the fiducial position mark setting section 313 additionally sets whether the fiducial position mark for mounting all the components to be mounted in the component mounting machine is the board mark 47 or the solder mark 48, and production starts. Then, at the time when the circuit boards are respectively carried and positioned in the component mounting machines, the mark camera 37 of the component mounting machine which is mounted with only one type of the component images only one type of the set fiducial position mark, and the image processing section 311 calculates the position of the imaged fiducial position mark for one type. In the component mounting machine which is mounted with only one type of the component, imaging and image processing needs to be performed with only one type of the fiducial position mark between the board mark 47 and the solder mark 48, and thus, production time is additionally shortened.

The invention is not limited to the above-described example. It is needless to mention that various changes can be made and be executed without departing from the scope of the invention, which is solely defined by the appended claims.

Reference Signs List

17 ... MOUNTING HEAD, 19 ... SUCTION NOZZLE, 23 ... COMPONENT CAMERA (COMPONENT IMAGING CAMERA), 31 ... CONTROL DEVICE (CONTROL MEANS), 34 ... STORAGE DEVICE, 35 ... BOARD CONVEYANCE DEVICE, 36 ... COMPONENT SUPPLY DEVICE, 37 ... MARK CAMERA (MARK IMAGING CAMERA), 41 ... CIRCUIT BOARD, 42 ... PAD PATTERN, 43 ... COMPONENT, 44 ... PAD PATTERN, 45 ... SOLDER PRINTING PATTERN, 46 ... COMPONENT, 47 ... BOARD MARK, 48 ... SOLDER MARK, 50 ... MULTI-PIECE BOARD, 311 ... IMAGE PROCESSING SECTION, 312 ... COMPONENT DETERMINATION SECTION, 313... FIDUCIAL POSITION MARK SETTING SECTION, 314 ... CORRECTION AMOUNT CALCULATING SECTION

## Claims

1. A component mounting machine for mounting a component supplied from a component supply device (36) on a pad pattern (42) of a circuit board (41) or a solder printing pattern (45) formed by performing screen printing on the pad pattern (44),
   wherein the component mounting machine comprises:

   a camera (37) that is configured to image an imaging target portion of the circuit board (41); and
   control means (31) that is configured to control a component mounting operation by determining whether a mount component is the component (43) to be mounted on the pad pattern (42) or the component (46) to be mounted on the solder printing pattern (45), and
   wherein the control means (31) includes means for correcting a mounting position of a component (43) with respect to the pad pattern (42) based on a position of a board mark (47) formed on the circuit board (41) as a fiducial point which is imaged by the camera (37) and is subjected to image processing (311) and mounting the component (43) on the pad pattern (42) when it is determined that the mount component is the component (43) to be mounted on the pad pattern (42), and means for correcting a mounting position of a component (46) with respect to the solder printing pattern (45) based on a position of a solder mark (48) formed on the circuit board (41) as a fiducial point which is imaged by the camera (37) and is subjected to image processing (311) and mounting the component (46) on the solder printing pattern (45) when it is determined that the mount component is the component (46) to be mounted on the solder printing pattern (45);
   wherein the control means (31) is configured to determine that the mount component is the component (43) to be mounted on the pad pattern (42) when screen printing of the solder printing pattern (45) is not performed on the pad pattern (42) existing at a component mounting position or when application of solder is performed on the pad pattern (42) existing at the component mounting position by a method other than screen printing or when the mount component is the component (43) to be mounted after solder or flux is transferred to a terminal portion thereof, and is configured to determine that the mount component is the component (46) to be mounted on the solder printing pattern (45) when screen printing of the solder printing pattern (45) is performed on the pad pattern (44) existing at the component mounting position,

wherein the control means (31) is configured to determine that the mount component is the component (43) to be mounted on the pad pattern (42) or the component (46) to be mounted on the solder printing pattern (45), with reference to image processing component data, mounting position data or the like,

said data including data for designating whether the mount component is the component (43) to be mounted on the pad pattern (42) or the component (46) to be mounted on the solder printing pattern (45).

**2.** The component mounting machine according to Claim 1,
wherein a pad pattern (42) the position of which can be specified through image recognition is used as the board mark (47) among the pad patterns (42) of the circuit board (41).

**3.** The component mounting machine according to Claim 1 or 2,
wherein a solder printing pattern (45) the position of which can be specified through image recognition is used as the solder mark (48) among the solder printing patterns (45) formed by performing screen printing on the pad patterns (44) of the circuit board (41).

**4.** A component mounting method for mounting a component supplied from a component supply device (36) on a pad pattern (42) of a circuit board (41) or a solder printing pattern (45) formed by performing screen printing on the pad pattern (44),

wherein it is determined whether a mount component is the component (43) to be mounted on the pad pattern (42) or the component to be mounted on the solder printing pattern (45), and in accordance with the result thereof, a mounting position of a component (43) is corrected with respect to the pad pattern (42) based on a position of a board mark (47) formed on the circuit board as a fiducial point which is imaged by a camera (37) and is subjected to image processing (311) and the component (43) is mounted on the pad pattern (42) when it is determined that the mount component is the component (43) to be mounted on the pad pattern (42) while the mounting position of the component (46) is corrected with respect to the solder printing pattern (45) based on a position of a solder mark (48) formed on the circuit board as a fiducial point which is imaged by the camera (37) and is subjected to image processing (311) and the component (46) is mounted on the solder printing pattern (45) when it is determined that the mount component is the component (46) to be mounted on the solder printing pattern (45),

wherein it is determined that the mount component is the component (43) to be mounted on the pad pattern (42) when screen printing of the solder printing pattern (45) is not performed on the pad pattern (42) existing at a component mounting position or when application of solder is performed on the pad pattern (42) existing at the component mounting position by a method other than screen printing or when the mount component is the component (43) to be mounted after solder or flux is transferred to a terminal portion thereof, and it is determined that the mount component is the component (46) to be mounted on the solder printing pattern (45) when screen printing of the solder printing pattern (45) is performed on the pad pattern (44) existing at the component mounting position,

wherein it is determined that the mount component is the component (43) to be mounted on the pad pattern (42) or the component (46) to be mounted on the solder printing pattern (45), with reference to image processing component data, mounting position data or the like,

said data including data for designating whether the mount component is the component (43) to be mounted on the pad pattern (42) or the component (46) to be mounted on the solder printing pattern (45).

**Patentansprüche**

**1.** Maschine zum Montieren von Bauteilen, mit der ein von einer Bauteil-Zuführvorrichtung (36) zugeführtes Bauteil an einem Kontaktstellen-Muster (42) einer Leiterplatte (41) oder einem Lot-Druckmuster (45) montiert wird, das mittels Durchführen von Siebdrucken an dem Kontaktstellen-Muster (44) ausgebildet wird,
wobei die Maschine zum Montieren von Bauteilen umfasst:

eine Kamera (37), die so ausgeführt ist, dass sie einen Abbildungsobjekt-Abschnitt der Leiterplatte (41) abbildet; sowie

eine Steuerungseinrichtung (31), die so ausgeführt ist, dass sie einen Vorgang zum Montieren von Bauteilen steuert, indem sie feststellt, ob ein Montage-Bauteil das an dem Kontaktstellen-Muster (42) zu montierende Bauteil (43) oder das an dem Lot-Druckmuster (45) zu montierende Bauteil (46) ist, und

wobei die Steuerungseinrichtung (31) eine Einrichtung, mit der eine Montage-Position eines Bauteils (43) in Bezug auf das Kontaktstellen-Muster (42) auf Basis einer Position einer auf der Leiterplatte (41) ausgebildeten Platten-Markierung (47) als einem Bezugspunkt korrigiert wird, der durch die Kamera (37) abgebildet und Bildverarbeitung (311) unterzogen wird, und das Bauteil (43) an dem Kontaktstellen-Muster (42) montiert wird, wenn festgestellt wird, dass das Montage-Bauteil das an dem Kontaktstellen-Muster (42) zu montierende Bauteil (43) ist, sowie eine Einrichtung enthält, mit der eine Montageposition eines Bauteils (46) in Bezug auf das Lot-Druckmuster (45) auf Basis einer Position einer auf der Leiterplatte (41) ausgebildeten Lot-Markierung (48) als einem Bezugspunkt korrigiert wird, der durch die Kamera (37) abgebildet und Bildverarbeitung (311) unterzogen wird, und das Bauteil (46) an dem Lot-Druckmuster (45) montiert wird, wenn festgestellt wird, dass das Montage-Bauteil das an dem Lot-Druckmuster (45) zu montierende Bauteil (46) ist;

die Steuerungseinrichtung (31) so ausgeführt ist, dass sie feststellt, dass das Montage-Bauteil das an dem Kontaktstellen-Muster (42) zu montierende Bauteil (43) ist, wenn kein Siebdrucken des Lot-Druckmusters (45) an dem Kontaktstellen-Muster (42) durchgeführt wird, das an einer Bauteil-Montageposition vorhanden ist, oder wenn Aufbringen von Lot an dem an der Bauteil-Montageposition vorhandenen Kontaktstellen-Muster (42) mit einem anderen Verfahren als Siebdrucken durchgeführt wird, oder wenn das Montage-Bauteil das Bauteil (43) ist, das zu montieren ist, nachdem Lot oder Flussmittel auf einen Anschlussabschnitt desselben übertragen worden ist, und so ausgeführt ist, dass sie feststellt, dass das Montage-Bauteil das auf dem Lot-Druckmuster (45) zu montierende Bauteil (46) ist, wenn Siebdrucken des Lot-Druckmusters (45) an dem an der Bauteil-Montageposition vorhandenen Kontaktstellen-Muster (44) durchgeführt wird,

die Steuerungseinrichtung (31) so ausgeführt ist, dass sie unter Bezugnahme auf Bildverarbeitungs-Bauteil-Daten, Montagepositions-Daten oder dergleichen feststellt, dass das Montage-Bauteil das an dem Kontaktstellen-Muster (42) zu montierende Bauteil (43) oder das an dem Lot-Druckmuster (45) zu montierende Bauteil (46) ist,

wobei die Daten Daten einschließen, die angeben, ob das Montage-Bauteil das an dem Kontaktstellen-Muster (42) zu montierende Bauteil (43) oder das an dem Lot-Druckmuster (45) zu montierende Bauteil (46) ist.

2. Maschine zum Montieren von Bauteilen nach Anspruch 1,
   wobei von den Kontaktstellen-Mustern (42) der Leiterplatte (41) als die Platten-Markierung (47) ein Kontaktstellen-Muster (42) verwendet wird, dessen Position mittels Bilderkennung bestimmt werden kann.

3. Maschine zum Montieren von Bauteilen nach Anspruch 1 oder 2,
   wobei von den Lot-Druckmustern (45), die mittels Durchführen von Siebdrucken an den Kontaktstellen-Mustern (44) der Leiterplatte (41) ausgebildet werden, als die Lot-Markierung (48) ein Lot-Druckmuster (45) verwendet wird, dessen Position mittels Bilderkennung bestimmt werden kann.

4. Verfahren zum Montieren von Bauteilen, mit dem ein von einer Bauteil-Zuführvorrichtung (36) zugeführtes Bauteil an einem Kontaktstellen-Muster (42) einer Leiterplatte (41) oder einem Lot-Druckmuster (45) montiert wird, das mittels Durchführen von Siebdruck an dem Kontaktstellen-Muster (44) ausgebildet wird,
   wobei festgestellt wird, ob ein Montage-Bauteil das an dem Kontaktstellen-Muster (42) zu montierende Bauteil (43) oder das an dem Lot-Druckmuster (45) zu montierende Bauteil ist, und entsprechend dem Ergebnis eine Montageposition eines Bauteils (43) auf Basis einer Position einer auf der Leiterplatte (41) ausgebildeten Platten-Markierung (47) als einem Bezugspunkt korrigiert wird, der durch eine Kamera (37) abgebildet und Bildverarbeitung (311) unterzogen wird, und das Bauteil (43) an dem Kontaktstellen-Muster (42) montiert wird, wenn festgestellt wird, dass das Montage-Bauteil das an dem Kontaktstellen-Muster (42) zu montierende Bauteil (43) ist, und gleichzeitig die Montageposition des Bauteils (46) in Bezug auf das Lot-Druckmuster (45) auf Basis einer Position einer auf der Leiterplatte (41) ausgebildeten Lot-Markierung (48) als einem Bezugspunkt korrigiert wird, der durch die Kamera (37) abgebildet und Bildverarbeitung (311) unterzogen wird, und das Bauteil (46) an dem Lot-Druckmuster (45) montiert wird, wenn festgestellt wird, dass das Montage-Bauteil das an dem Lot-Druckmuster (45) zu montierende Bauteil (46) ist;
   festgestellt wird, dass das Montage-Bauteil das an dem Kontaktstellen-Muster (42) zu montierende Bauteil (43) ist, wenn kein Siebdrucken des Lot-Druckmusters (45) an dem Kontaktstellen-Muster (42) durchgeführt wird, das an einer Bauteil-Montageposition vorhanden ist, oder wenn Aufbringen von Lot an dem an der Bauteil-Montageposition vorhandenen Kontaktstellen-Muster (42) mit einem anderen Verfahren als Siebdrucken durchgeführt wird, oder wenn das Montage-Bauteil das Bauteil (43) ist, das zu montieren ist, nachdem Lot oder Flussmittel auf einen Anschlussabschnitt desselben übertragen worden ist, und festgestellt wird, dass das Montage-Bauteil das an dem Lot-Druckmuster (45) zu montierende Bauteil (46) ist, wenn Siebdrucken des Lot-Druckmusters (45) an dem an der Bauteil-Montageposition vorhandenen Kontaktstellen-Muster (44) durchgeführt wird,

unter Bezugnahme auf Bildverarbeitungs-Bauteil-Daten, Montagepositions-Daten oder dergleichen festgestellt wird, dass das Montage-Bauteil das an dem Kontaktstellen-Muster (42) zu montierende Bauteil (43) oder das an dem Lot-Druckmuster (45) zu montierende Bauteil (46) ist,

wobei die Daten Daten einschließen, die angeben, ob das Montage-Bauteil das an dem Kontaktstellen-Muster (42) zu montierende Bauteil (43) oder das an dem Lot-Druckmuster (45) zu montierende Bauteil (46) ist.

## Revendications

1.  Machine de montage de composants destinée à monter un composant fourni à partir d'un dispositif de délivrance de composants (36) sur un motif de plage (42) d'une carte à circuit imprimé (41) ou sur un motif d'impression de soudure (45) élaboré en effectuant une sérigraphie sur le motif de plage (44),

    la machine de montage de composants comprenant :

    un appareil de prise de vues (37) qui est configuré pour former en image un élément cible d'imagerie de la carte à circuit imprimé (41), et

    un moyen de commande (31) qui est configuré pour piloter une opération de montage de composants en déterminant si un composant de montage est le composant (43) à monter sur le motif de plage (42) ou bien le composant (46) à monter sur le motif d'impression de soudure (45), et

    dans laquelle le moyen de commande (31) inclut un moyen permettant de corriger une position de montage pour un composant (43) par rapport au motif de plage (42) sur la base de la position d'un repère de carte (47) formé sur la carte à circuit imprimé (41) sous la forme d'un point de centrage qui est mis en image par l'appareil de prise de vues (37) et qui est soumis à un traitement d'image (311), et le montage du composant (43) sur le motif de plage (42) lorsque l'on détermine que le composant de montage est le composant (43) à monter sur le motif de plage (42) ; ainsi qu'un moyen permettant de corriger la position de montage d'un composant (46) par rapport au motif d'impression de soudure (45) sur la base de la position d'un repère de soudure (48) formé sur la carte à circuit imprimé (41) sous la forme d'un point de centrage qui est mis en image par l'appareil de prise de vues (37) et qui est soumis à un traitement d'image (311), et le montage du composant (46) sur le motif d'impression de soudure (45) lorsque l'on détermine que le composant de montage est le composant (46) à monter sur le motif d'impression de soudure (45),

    dans laquelle le moyen de commande (31) est configuré pour déterminer que le composant de montage est le composant (43) à monter sur le motif de plage (42) lorsque la sérigraphie du motif d'impression de soudure (45) n'est pas réalisée sur le motif de plage (42) existant au niveau de la position de montage du composant, ou lorsque l'application de soudure est effectuée sur le motif de plage (42) existant au niveau de la position de montage du composant grâce à un procédé différent de la sérigraphie, ou bien lorsque le composant de montage est le composant (43) à monter après qu'une soudure ou qu'un flux a été transféré sur une partie terminale de celui-ci ; et il est configuré pour déterminer que le composant de montage est le composant (46) à monter sur le motif d'impression de soudure (45) lorsque la sérigraphie du motif d'impression de soudure (45) a été effectuée sur le motif de plage (44) existant au niveau de la position de montage de composant,

    dans laquelle le moyen de commande (31) est configuré pour déterminer que le composant de montage est le composant (43) à monter sur le motif de plage (42) ou le composant (46) à monter sur le motif d'impression de soudure (45) en faisant référence à des données de composants après traitement d'image, à des données de position de montage ou autres,

    lesdites données incluant des données permettant la désignation de ce que le composant de montage est le composant (43) à monter sur le motif de plage (42) ou bien le composant (46) à monter sur le motif d'impression de soudure (45).

2.  Machine de montage de composants selon la revendication 1,
    dans laquelle un motif de plage (42), dont la position peut être spécifiée par l'intermédiaire d'une reconnaissance d'image, est utilisé comme repère de carte (47) parmi les motifs de plages (42) de la carte à circuit imprimé (41).

3.  Machine de montage de composants selon la revendication 1 ou la revendication 2,
    dans laquelle un motif d'impression de soudure (45), dont la position peut être spécifiée par l'intermédiaire d'une reconnaissance d'image, est utilisé comme repère de soudure (48) parmi les motifs d'impression de soudure (45) formés en effectuant une sérigraphie sur les motifs de plages (44) de la carte à circuit imprimé (41).

4. Procédé de montage du composant permettant de monter un composant fourni à partir d'un dispositif de délivrance de composants (36) sur un motif de plage (42) d'une carte à circuit imprimé (41) ou sur un motif d'impression de soudure (45) élaboré en effectuant une sérigraphie sur le motif de plage (44),

dans lequel il est déterminé si un composant de montage est le composant (43) à monter sur le motif de plage (42) ou le composant à monter sur le motif d'impression de soudure (45), et en fonction du résultat de cette opération, la position de montage d'un composant (43) est corrigée par rapport au motif de plage (42) sur la base de la position d'un repère de carte (47) formé sur la carte à circuit imprimé sous la forme d'un point de centrage qui est mis en image par un appareil de prise de vues (37) et qui est soumis à un traitement d'image (300), et le composant (43) est monté sur le motif de plage (42) lorsqu'il est déterminé que le composant de montage est le composant (43) à monter sur le motif de plage (42) ; alors que la position de montage du composant (46) est corrigée par rapport au motif d'impression de soudure (45) sur la base de la position d'un repère de soudure (48) formé sur la carte à circuit imprimé sous la forme d'un point de centrage qui est mis en image par un appareil de prise de vues (37) et qui est soumis à un traitement d'image (311), et le composant (46) est monté sur le motif d'impression de soudure (45) lorsqu'il est déterminé que le composant de montage est le composant (46) à monter sur le motif d'impression de soudure (45),

dans lequel il est déterminé que le composant de montage est le composant (43) à monter sur le motif de plage (42) lorsqu'aucune sérigraphie du motif d'impression de soudure (45) n'est réalisée sur le motif de plage (42) existant au niveau d'une position de montage de composant ou lorsqu'une application de soudure est effectuée sur le motif de plage (42) existant au niveau de la position de montage de composant grâce à un procédé différent de la sérigraphie ou bien lorsque le composant de montage est le composant (43) à monter après qu'une soudure ou qu'un flux est transféré sur une partie terminale de celui-ci, et il est déterminé que le composant de montage est le composant (46) à monter sur le motif d'impression de soudure (45) lorsqu'une sérigraphie du motif d'impression de soudure (45) est effectuée sur le motif de plage (44) existant au niveau de la position de montage de composant,

dans lequel il est déterminé que le composant de montage est le composant (43) à monter sur le motif de plage (42) ou bien le composant (46) à monter sur le motif d'impression de soudure (45) en faisant référence à des données de composants après traitement d'image, à des données de position de montage ou autres,

lesdites données incluant des données permettant la désignation de ce que le composant de montage est le composant (43) à monter sur le motif de plage (42) ou bien le composant (46) à monter sur le motif d'impression de soudure (45).

[Fig. 1]

[Fig. 2]

[Fig. 3]

(a)
BEFORE SCREEN PRINTING
PERFORMED

(b)
AFTER SCREEN PRINTING
PERFORMED

(c)
AFTER COMPONENT
MOUNTED

[Fig. 4]

[Fig. 5]

```
        ╭─────────────────────╮
        │ COMPONENT MOUNTING  │
        │  CONTROL PROGRAM    │
        ╰─────────────────────╯
                   │
      ┌─────────────────────────────┐
    ║ │   COMPONENT MOUNTING        │ ║  ⌇ 101
      │  SKIPPING DETERMINATION     │
      └─────────────────────────────┘
                   │               102
              ╱────────────╲
           ╱  IS MOUNT COMPONENT  ╲         No
        ╱  = COMPONENT TO BE MOUNTED  ╲────────────────────┐
           ╲  IN SOLDER PRINTING   ╱                       │
              ╲  PATTERN ?  ╱                               │
                   │                                        │
                  Yes      103                     104      │
      ┌───────────────────────────┐    ┌───────────────────────────┐
      │  FIDUCIAL POSITION MARK   │    │  FIDUCIAL POSITION MARK   │
      │     = SOLDER MARK         │    │     = BOARD MARK          │
      └───────────────────────────┘    └───────────────────────────┘
                   │                                 │
                   ▶◀─────────────────────────────────
                   │
      ┌───────────────────────────┐
      │  BLOCK NUMBER n ← n+1     │  ⌇ 105
      └───────────────────────────┘
          (INITIALIZATION VALUE OF n = 0)
                   │       106
              ╱────────────╲
           ╱  IS SKIPPING    ╲           No
        ╱  DETERMINATION FLAG IN  ╲──────────────┐
           ╲  BLOCK OF BLOCK NUMBER n  ╱          │
              ╲  = ON ?  ╱                        │       108
                   │                         ╱────────────╲
                  Yes                     ╱  IS FIDUCIAL    ╲      No
                   │                   ╱  POSITION MARK  ╲──────────┐
       107         │                      ╲  = SOLDER MARK ╱        │
                   │                         ╲  ?  ╱                │
      ┌───────────────────────────┐             │                  │
      │  SKIP BLOCK OF BLOCK      │            Yes                  │
      │  NUMBER n FROM MOUNT      │             │                   │
      │     COMPONENT             │      109    │             110   │
      └───────────────────────────┘    ┌───────────────────┐  ┌───────────────────┐
                   │                    │ CORRECT MOUNTING  │  │ CORRECT MOUNTING  │
                   │                    │ POSITION AND      │  │ POSITION AND      │
                   │                    │ MOUNT COMPONENT   │  │ MOUNT COMPONENT   │
                   │                    │ BASED ON POSITION │  │ BASED ON POSITION │
                   │                    │ OF SOLDER MARK IN │  │ OF BOARD MARK IN  │
                   │                    │ BLOCK NUMBER n AS │  │ BLOCK NUMBER n AS │
                   │                    │ FIDUCIAL POINT    │  │ FIDUCIAL POINT    │
                   │                    └───────────────────┘  └───────────────────┘
                   │                             │                  │
                   ◀─────────────────────────────┴──────────────────
                   │       111
      No      ╱────────────╲
  ┌──────────╱  IS BLOCK NUMBER n  ╲
  │          ╲  LAST BLOCK NUMBER  ╱
  │             ╲  ?  ╱
  │                │
  │               Yes
  │          ╭──────────────╮
  │          │   RETURN     │
  │          ╰──────────────╯
  └─────────────┘
```

19

[Fig. 6]

COMPONENT MOUNTING SKIPPING
DETERMINATION PROGRAM

201

IS SKIPPING-DETERMINED
FLAG = OFF?

No → RETURN

Yes

IMAGE BOARD MARK IN EACH BLOCK AND
PERFORM IMAGE RECOGNITION OF POSITION OF BOARD MARK — 202

IMAGE SOLDER MARK IN EACH BLOCK AND
PERFORM IMAGE RECOGNITION OF POSITION OF SOLDER MARK — 203

CALCULATE AMOUNT OF POSITIONAL MISALIGNMENT
BETWEEN BOARD MARK AND SOLDER MARK FOR EACH BLOCK — 204

BLOCK NUMBER $n \leftarrow n+1$ — 205

(INITIALIZATION VALUE OF $n = 0$)

206

IS AMOUNT OF
POSITIONAL MISALIGNMENT
IN BLOCK OF BLOCK NUMBER $n$
> MAXIMUM PERMISSIBLE AMOUNT OF
POSITIONAL MISALIGNMENT
?

No

Yes    207                                              208

SKIPPING DETERMINATION FLAG IN
BLOCK OF BLOCK NUMBER $n$ = ON
(SKIP)

SKIPPING DETERMINATION FLAG IN
BLOCK OF BLOCK NUMBER $n$ = OFF

209

No ← IS BLOCK NUMBER $n$
LAST BLOCK NUMBER
?

Yes

SKIPPING-DETERMINED FLAG = ON — 210

RETURN

[Fig. 7]

CONTROL DEVICE — 31

IMAGE PROCESSING
SECTION — 311

COMPONENT
DETERMINATION SECTION — 312

FIDUCIAL POSITION
MARK SETTING SECTION — 313

CORRECTION AMOUNT
CALCULATING SECTION — 314

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3983274 B

- EP 1239719 A2